**Europäisches Patentamt**

**European Patent Office**

**Office européen des brevets**

(11) Veröffentlichungsnummer: **0 004 306**
**B1**

(12) # EUROPÄISCHE PATENTSCHRIFT

(21) Anmeldenummer: **79100651.3**

(22) Anmeldetag: **05.03.79**

(51) Int. Cl.³: **H 04 L 25/08, H 03 K 17/08**

(54) **Schaltungsanordnung zum Schutz elektronischer Sende- und Empfangseinrichtungen gegen Überstrom.**

(30) Priorität: **20.03.78 DE 2812157**

(43) Veröffentlichungstag der Anmeldung:
**03.10.79 Patentblatt 79/20**

(45) Bekanntmachung des Hinweises auf die Patenterteilung:
**04.02.81 Patentblatt 81/5**

(84) Benannte Vertragsstaaten:
**BE DE IT NL SE**

(56) Entgegenhaltungen:
**FR - A - 1 266 303**
**FR - A - 1 529 927**
**US - A - 3 581 119**

**TOUTE L'ELECTONIQUE, Nr. 426,**
**November 1977, Paris,**
**"Protection d'un transistor de**
**commutation", Seite 95**

**GB - A - 989 790**

(73) Patentinhaber: **SIEMENS AKTIENGESELLSCHAFT**
**Berlin und München**
**Postfach 22 02 61**
**D-8000 München 22 (DE)**

(72) Erfinder: **Schuhbauer, Ernst, Dipl.-Ing.**
**Sonnwendjochstrasse 86**
**D-8000 München 82 (DE)**

## Schaltungsanordnung zum Schutz elektronischer Sende- und Empfangseinrichtungen gegen Überstrom

Die Erfindung bezieht sich auf eine Schaltungsanordnung zum Schutz elektronischer Sende- und Empfangseinrichtungen gegen Überströme in Anlagen der Gleichstromtelegrafietechnik.

Herkömmliche mit mechanischen Kontaken bzw. mit elektromagnetischen Empfangsschaltungen ausgerüstete Sende- bzw. Empfangseinrichtungen in Anlagen der Gleichstromtelegrafietechnik können derart dimensioniert werden, daß sie auch Ströme, die wesentlich über einen während des normalen Betriebs üblichen Wert antsteigen, zumindest so lange ohne nennenswerte Beschädigung aushalten können, bis ein Grobschutz, beispielsweise eine thermische Sicherung, anspricht. Sie stellen somit in der Regel recht robuste Geräte dar. In Anlagen mit solchen Geräten auf der Sende- und der Empfangsseite ist es deshalb ausreichend, den Stromfluß auf einen Stromwert zu begrenzen, der wesentlich über dem Normalwert liegt und ergänzend dazu lediglich Sicherungen vorzusehen, die nach einiger Zeit auf die Stromerhöhung ansprechen und dann den Stromfluß unterbrechen. Die Anwendung dieses Prinzips bedeutet, daß eine Strombegrenzerschaltung für eine sehr hohe Dauerverlustleistung ausgelegt werden muß. Geht man beispielsweise davon aus, daß in Anlagen der sogenannten Gleichstrom-Hochpegel-Telegrafietechnik mit Strömen zwischen 10 und 60 mA und mit Spannungen zwischen 48 V und 240 V gearbeitet wird und geht man weiter davon aus, daß der Wert für den Begrenzungssstrom 100 mA betragen darf, so ergibt sich z.B. bei einer Spannung von 120 V eine Dauerverlustleistung für die Begrenzerschaltung von 12 W. Einrichtungen, die eine derart hohe Dauerverlustleistung vertragen können, erfordern einen erheblichen Aufwand. Wird jedoch der Wert für den Begrenzungsstrom kleiner gewählt, so ergeben sich einerseits Toleranzprobleme und andererseits nehmen die Verzerrungen bei der Übertragung zu, da die Leitungskapazität dann zu langsam umgeladen wird. Im zuletzt erwähnten Fall sind dann weitere komplizierte Schaltungen erforderlich, die diese Nachteile ausgleichen.

Neben der Begrenzung des Stromes gibt es weiterhin die Möglichkeit, die Sende- und Empfangseinrichtungen selbst in Richtung größerer Robustheit zu dimensionieren. Das gelingt zunächst für eine elektronische Empfangsrichtung in der Weise, daß beispielsweise ein hochbelastbarer Meßwiderstand vorgesehen wird, der dann jedoch konstruktiv in einer solchen Weise in die Schaltung einzufügen ist, daß keine unzulässige Erwärmung der elektronischen Bauelemente deren Arbeitsweise beeinträchtigt. Gelingt das, so kann davon ausgegangen werden, daß ebenso wie in Empfangseinrichtungen mit elektromagnetischen Bauelementen bei höheren Strömen vor der Zerstörung der Empfangseinrichtung eine Sicherung auslöst. Derartige Anordnungen haben allerdings den Nachteil, daß sie nur dort eingesetzt werden können, wo Sicherungen vorgesehen sind. Bei Standverbindungen und in Anlagen, die in Abrufbetrieb arbeiten, sind jedoch sehr oft keine solchen Sicherungen vorgesehen. Für diesen Fall muß weiterhin eine zusätzliche Sollbruchstelle vorgesehen sein, an der bei länger andauerndem hohen Überstrom dann der Stromkreis unterbrochen wird. Fehlerhafte Anschaltungen, die relativ häufig vorkommen, führen dann zur Unterbrechung an der Sollbruchstelle.

Um eine Sendeeinrichtung mit elektronischen Bauelementen für Normalwerte hinausgehende Ströme relativ unempfindlich zu machen, besteht die Möglichkeit, daß der als Sendeschaltmittel verwendete Schalttransistor, der den im Normalbetrieb auftretenden Spitzenstrom schaltet, auch im Fehlerfall bis in die Sättigung gesteuert wird. Allerdings ist dann ein hoher Steuerstrom für den Schalttransistor erforderlich, der entweder über eine besondere Zusatzschaltung oder über eine zusätzliche Verstärkerstufe erzeugt wird. Wegen der starken Übersteuerung des Schalttransistors wird jedoch nicht nur das Schaltverhalten verschlechtert, was sich auf die Übertragungsgeschwindigkeit, auswirkt und zu Verzerrungen der zu übertragenden Zeichen führt, sondern es tritt auch im Normalbetrieb ein hoher Spannungssabfall auf. Wird ein zusätzlicher Verstärker verwendet, so ist eine zusätzliche Hilfsspannung für den Betrieb des Verstärkers erforderlich, die in vielen Fällen darüber hinaus auch noch potentialfrei, d.h. über eine galvanisch getrennte Zuführung zur Verfügung gestellt werden muß.

Neben den erwähnten Möglichkeiten, nämlich zum einen Maßnahmen zur Strombegrenzung vorzusehen und zum anderen die Überlastbarkeit elektronischer Sende- und Empfangseinrichtungen zu erhöhen, kann schließlich auch eine zusätzliche Sicherungsschaltung für die Sende- unde die Empfangseinrichtung Anwendung finden (DE - A - 2 360 689). eine solche elektronische Sicherungsschaltung beruht auf der Verwendung einer Schwellwertschaltung, die bei einem vorgegebenen Überstrom anspricht und damit den fehlerhaften Zustand kennzeichnet und den Strom abschaltet. In passend gewählten Zeitintervallen wird die Sicherungsschaltung wieder eingeschaltet und, falls der Normalzustand noch nicht hergestellt ist, wieder schnell abgeschaltet. Der Wechsel zwischen Ein- und Ausschaltung der Sicherungsschaltung wiederholt sich dann, wobei das Tastverhältnis derart festgelegt ist, daß der Schalttransistor in der Sendeeinrichtung selbst nicht überlastet wird. Dieses Prinzip erfordert für Vierdrahtanschlußschaltungen einen Zusatzaufwand für die Bewertung des Stromes in der Sendeeinrichtung und einen Zusatzaufwand für die Abschaltung des Stromes in der Empfangseinrichtung. Darüberhinaus sind sowohl in der Sende- als in der Empfangseinrichtung jeweils Zeitschaltungen für ein intervallmäßiges Anschalten der Sicherungsschaltung vorzusehen, die diesen Aufwand weiter erhöhen. Um die Übertragungsgüte nicht zu beeinträchtigen, ist auch hier sicherzustellen, daß ein genügend hoher kapazitiver Ladestrom fließen kann, was bedeutet, daß der Schwellwert für die Überstrombewertung in der Sicherungsschaltung relativ hoch liegen muß. Das bedeutet dann aber, daß der Schalttransistor mit einem ziemlich hohen Basisstrom angesteuert werden muß, der wiederum über eine eigene Schaltanordnung bzw. eine eigene Verstärkerschaltung mit Hilfsspannung erzeugt werden muß.

Die Aufgabe der Erfindung besteht darin, für Anlagen der Gleichstrom-Hochpegelanschlußtechnik eine Anordnung zum Schutz elektronischer Sende- und Empfangseinrichtungen gegen Überstrom anzugeben, die bei der Empfangseinrichtung weder eine Sicherung noch eine Sollbruchstelle erfordert und die es gestattet, bein der Sendeeinrichtung die Ansteuerung des Schalttransistors ohne zusätzliche Schaltungen, wie vorher erwähnt, zu ermöglichen. Dabei geht die Erfindung davon aus, daß sowohl die Empfangseinrichtung als auch die Sendeeinrichtung jeweils so dimensioniert sind, daß sie einen mittleren Überstrom dauernd, einen höheren Überstrom jedenfalls kurzzeitig ertragen können. Die erfindungsgemäße Lösung besteht darin, daß zum Schutz der Empfangseinrichtung ein in einer Ader der Anschlußleitung liegender Kaltleiter und ein diesem parallel geschalteter linearer Widerstand und zum Schutz der Sendeeinrichtung zusätzlich ein im Kollektorkreis des sendeseitigen Schalttransistors angeordneter Widerstand und ein der Kollektor-Basis-Strecke des Schalttransistors parallel liegender Hilfstransistor entgegengesetzen Leitfähigkeitstyps vorgesehen ist, der durch den Spannungsabfall am Widerstand steuerbar ist und über den bei Fließen eines Überstroms auf der Anschlußleitung ein zusätzlicher Basisstrom für den Schalttransistor erzeugt wird.

Zwar ist es in Schaltungsanordnungen zum Schutz elektronischer Einrichtungen an sich bekannt, den Spannungsabfall am Kollektorwiderstand eines Schalttransistors als Kriterium für die Einleitung einer Schutzmaßnahme heranzuziehen (FR - A - 15 29 927), doch ist der damit verbundene Aufwand beträchtlich. Ein Einsatz dieser Maßnahmen in Verbindung mit der Verwendung eines Kaltleiters ist nicht in Betracht gezogen worden.

Weitere Ausgestaltungen der Erfindung sind in den Unteransprüchen gekennzeichnet.

Einzelheiten der enfindungsgemäßen Schaltungsanordnung sowie deren Wirkungsweise werden im folgenden anhand der Zeichnung für Einfachstrombetrieb erläutert.

Dort zeigt
Fig. 1 die in einer Vierdrahtanschlußleitung liegende Schutzschaltung für eine Sende- und eine Empfangseinrichtung,
Fig. 2 eine Weiterbildung der Schutzschaltung für die Sendeeinrichtung und
Fig. 3 ein Beispiel für eine polungsunabhängige Schutzschaltung der Sende- und Empfangseinrichtung.

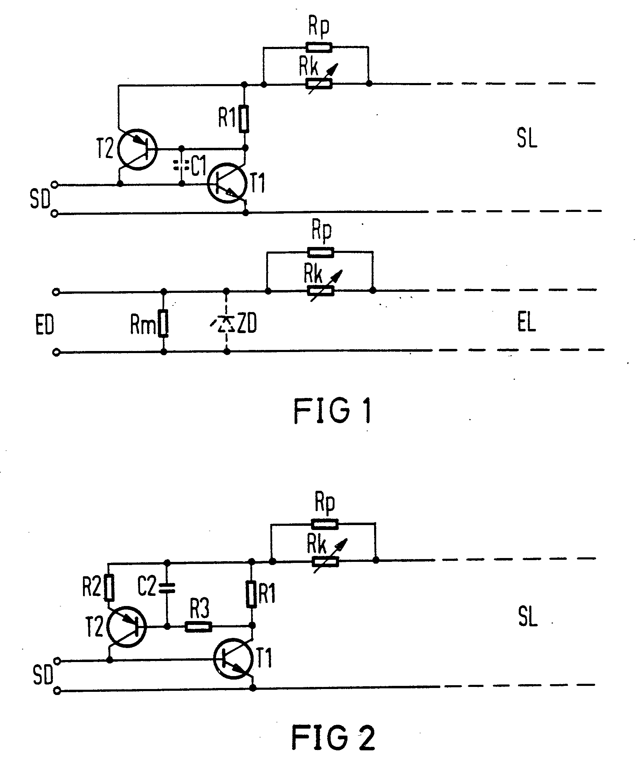

Das Ausführungsbeispiel in Fig. 1 ist zum Einsatz in einer Anlage für Einfachstrombetrieb und für eine vierardrige Anschlußleitung mit einer zweiadrigen Sendeleitung SL und einer zweiadrigen Empfangsleitung EL vorgesehen. Von der Sendeeinrichtung ist hier lediglich der Schalttransistor T1 dargestellt, der in nicht näher beschriebener Weise über seinen Basisanschluß durch die Sendedaten SD gesteuert wird. Die über die Empfangsleitung EL eintreffenden Zeichen werden als Empfangsdaten ED an eine ebenfalls nicht dargestellte Empfangseinrichtung weitergegeben. Voraussetzungsgemäß kann die Empfangseinrichtung einen mittleren Überstrom dauernd und einen höheren Überstrom kurzzeitig vertragen. In jeweils einer Ader der Sendeleitung SL und der Empfangsleitung EL ist jeweils ein Kaltleiter Rk angeordnet, dem ein linearer Widerstand Rp parallel geschaltet ist. Diese Anordnung hat gegenüber dem herkömmlichen Einsatz eines Kaltleiters allein den wesentlichen Vorteil, daß auch nach einem einmaligen Auftreten eines den Normalwert übersteigenden Stromes, also bei einem einmaligen Auftreten von Überstrom, nach Beendigung einer solchen Störung die Anordnung auch ohne zusätzliche Maßnahmen weiterhin betriebsfähig ist. Während mit dem Einsatz eines Kaltleiters ohne Überbrückung durch einen Widerstand zur Wiederaufnahme des Betriebs nach dem einmaligen Auftreten eines Überstroms die Leitung für eine längere Zeitdauer in der Regel manuell unterbrochen werden muß, tritt mit der erfindungsgemäßen Anordnung näherungsweise eine Regelung des Stromes ein, ohne daß wie bei anderen Regelungs- oder Begrenzungsschaltungen, nach Wiederherstellung des Normalsbetriebs ein hoher Restwiderstand im Stromkreis verbleibt. Diese im vorhergehenden beschriebene Wirkungsweise sowie die technisch ohne nennenswerten Aufwand erreichbare Überlastbarkeit der Empfangseinrichtung, der dazu in an sich bekannter Weise ein hochbelastbarer Widerstand Rm vorgeschaltet ist, stellt für die Empfangseinrichtung einen ausreichenden Schutz dar. Für den Fall, daß die Empfangseinrichtung und/oder der Meßwiderstand Rm vor der Empfangseinrichtung wenig belastbar ist, kann bedarfsweise eine Zenerdiode ZD vorgesehen werden, die in Fig. 1 gestrichelt eingezeichnet wurde.

Für die Sendeeinrichtung bringt die Anordnung des mit einem linearen Widerstand Rp überbrückten Kaltleiters Rk in der Sendeleitung SL nur dann den gewünschten Erfolg, wenn die Sendeeinrichtung selbst hoch dimensioniert wird. Aus diesem Grunde ist ein im Kollektoranschluß des Schalttransistors T1 liegender Widerstand R1 un zwischen der Basis und dem Kollektor des Schalttransistors T1 ein Hilfstransistor T2 entgegengesetzten Leitfähigkeitstyps vorgesehen. Die Steuerung des Hilfstransistors T2 erfolgt über den Spannungsabfall am Widerstand R1. Im Normalbetrieb ist der Spannungsabfall am Widerstand R1 so gering, daß der Hilfstransistor T2 gesperrt ist. In diesem Falle wird der Schalttransistor T1 allein durch die Sendedaten SD gesteuert, wobei in normalen Betrieb der Steuerstrom lediglich eine sichere Durchsteuerung des Schalttransistors T1 gewährleisten muß. Steigt der Strom dagegen auf einen unzulässigen hohen Wert an, so erhöht sich der Spannungsabfall am Widerstand R1 und der Hilfstransistor T2 wird in den leitenden Zustand gesteuert. Dadurch erhält der Schalttransistor T1 nun zusätzlich einen hohen Basisstrom, der ihn sicher in den Sättigungszustand überführt und dort hält. Mit der erfindungsgemäßen Anordnung wird somit erreicht, daß die zur Steuerung des Schalttransistors in den gesättigten Zustand erforderlichen hohen Steuerströme lediglich während des Fließens von Überstrom mit einer einfachen Schaltungsanordnung erzeugt werden. Sinkt der Überstrom wieder ab, wird der Schalttransistor T1 wieder normal steuerbar und die Schutzfunktion der Anordnung steht wieder voll zur Verfügung.

In Ausgestaltung der Erfindung können mit Hilfe eines zwischen die Basisanschlüsse des Hilfstransistors T2 und des Schalttransistors T1 geschalteten Kondensators C1 die durch die Steuerung des Schalttransistors T1 erzeugten Schaltflanken abgeflacht werden. Dadurch wird der Anteil von Oberwellen im ausgesendeten Signal rezuziert, was zu einer Verbesserung der Übertragungseigenschaften führt. Der bedarfsweise einzusetzende Kondensator C1 ist in Fig. 1 ebenfalls gestrichelt eingetragen worden.

Die Schutzschaltung für die Sendeeinrichtung kann, wie in Fig. 2 dargestellt ist, dadurch weiter verbessert werden, daß im Emitteranschluß de Hilfstransistors T2 ein weiterer Widerstand R2 und/oder ein zusätzliches RC-Glied R3 C2 vorgesehen ist, mit dem eine Ansprechverzögerung der Schutzfunktion erreichbar ist. Die Wirkungsweise der in Fig. 2 dargestellten Anordnung ist dabei die gleiche bereits anhand von Fig. 1 erläutert wurde. Auch hier wird über den Spannungsabfall am Widerstand R1 der Hilfstransistor T2 stets dann in den leitenden Zustand gesteuert, wenn der auf der Sendeleitung fließende Strom einen bestimmten über den Normalwert liegenden Wert erreicht hat. Mit Hilfe des Widerstandes R2 kann hier jedoch bei Fießen eines Überstromes

die Stromaufteilung in den beiden Zweigen der Anordnung und damit auch der Basisstrom des Schalttransistors T1 beeinfluß werden. Durch geeignete Dimensionierung der RC-Kombination R3C2 wird in an sich bekannter Weise die Steuerung des Hilfstransistors T2 vom gesperrten Zustand im Normalbetrieb in den leitenden Zustand im Störungsfalle verzögert wirksam.

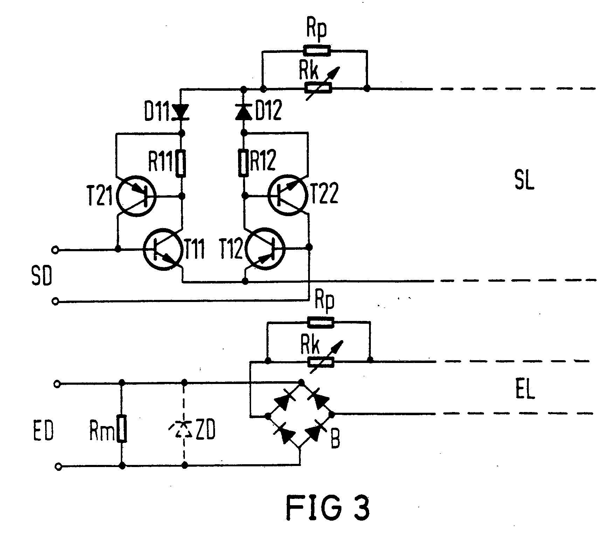

Bisher wurde die Erfindung anhand eines Beispiels für eine Stromrichtung erläutert. Mit den gleichen Vorteilen kann die erfindungsgemäße Anordnung aber auch in Anlagen eingesetzt werden, in denen ein polungsunabhängiger Betrieb erforderlich ist. Ein Beispiel dafür zeigt Fig. 3. Dort sind zwei aus je einem Schalttransistor und je einem über den im Kollektorkreis des Schalttransistors liegenden Widerstand steuerbaren Hilfstransistors bestehende Anordnungen für den Schutz der Sendeeinrichtung parallel geschaltet, während zum Schutz der Empfangseinrichtung in diesem Falle die Polungsabhängigkeit durch eine Gleichrichterbrückenschaltung erreicht wird. Die Anordnung gemäß Fig. 3 enthält dazu zwei Schalttransistoren T11 und T12 von entgegengesetzten Leitfähigkeitstyps, zwei Widerstände R11 und R12 sowie zwei Hilfstransistoren T21 und T22 vom Leitfähigkeitstyp, der dem des ihnen jeweils zugeordneten Schalttransistors entgegengesetzt ist. Im Normalbetrieb werden die Schalttransistoren T11 und T12 polungsabhängig durch die Sendedaten SD gesteuert, während im Falle eines Überstromes über die beiden Hilfstransistoren T21 und T22 der zusätzliche Basisstrom für die beiden Schalttransistoren T11 und T12 in beschriebener Weise erzeugt wird. Über die Dioden D11 und D12, die jeweils für eine der beiden Stromrichtungen durchlässig sind, ist die Anordnung mit einer Ader der Sendeleitung SL verbunden. Im Ausführungsbeispiel ist in dieser Ader auch der Kaltleiter Rk und der ihn überbrückende Widerstand Rp angeordnet.

Die gezeigte Schutzschaltung mit parallel geschalteten Transistoren entgegengesetzten Leitfähigkeitstyps für die Sendeeinrichtung erfordert keine Gleichrichterbrückenschaltung für die Schalttransistoren und vermeidet daher den bei Anordnungen mit Gleichrichterbrückenschaltungen auftretenden höheren Spannungsabfall.

In der Empfangsleitung EL ist die Gleichrichterbrückenschaltung B vorgesehen, an der an jeweils gegenüberliegenden Schaltpunkten die Anschlüsse zur Abgabe der Empfangsdaten ED und die beiden Adern der Empfangsleitung EL angeschaltet sind, wobei der durch den den Widerstand Rp überbrückte Kaltleiter Rk in einer dieser beiden Adern angeordnet ist.

## Patentansprüche

1. Schaltungsanordnung zum Schutz elektronischer Sende- und Empfangseinrichtungen gegen Überströme in Anlagen der Gleichstromtelegrafietechnik, dadurch gekennzeichnet, daß in jeweils einer Ader einer Sende- und/oder einer Empfangsleitung ein Kaltleiter (Rk) und ein diesem parallel geschalteter linearer Widerstand (Rp) vorgesehen ist, daß ein im Kollektoranschluß eines in der Sendeeinrichtung vorgesehenen Schalttransistors (T1) angeordneter Widerstand (R1) und ein der Kollektor-Basis-Strecke des Schalttransistors (T1) parallel liegender Hilfstransistor (T2) entgegengesetzten Leitfähigkeitstyps vorgesehen ist, der durch den Spannungsabfall am Widerstand (R1) steuerbar ist und über den bei Fließen eines Überstroms auf der Anschlußleitung (SL) ein zusätzlicher Basisstrom für den Schalttransistor (T1) erzeugt wird.

2. Schaltungsanordnung nach Anspruch 1, dadurch gekennzeichnet, daß zwischen dem Basisanschluß des Schalttransistors (T1) und dem Basisanschluß des Hilfstransistors (T2) ein Kondensator (C1) angeordnet ist.

3. Schaltungsanordnung nach einem der Ansprüche 1 oder 2, dadurch gekennzeichnet, daß in der Kollektorstrecke des Hilfstransistors (T2) ein weiterer Widerstand (R2) angeordnet ist.

4. Schaltungsanordnung nach einem der Ansprüche 1 bis 3, dadurch gekennzeichnet, daß im Basisstromkreis des Hilfstransistors (T2) eine Ansprechverzögerungsschaltung (R3, C2) vorgesehen ist.

5. Schaltungsanordnung für polungsun-abhängig betriebene Sende- und Empfangs-einrichtungen nach einem der Ansprüche 1 bis 4, dadurch gekennzeichnet, daß zwischen den Anschlüssen für die Empfangsdaten (ED) und der Empfangsleitung (EL) eine Gleichrichterbrückenschaltung (B) vorgesehen ist, daß zwischen den Anschlüssen für die Sendedaten (SD) und der Sendeleitung (SL) Schalttransistoren (T11 bzw. T12) und je ein über den im Kollektoranschluß jedes Schalttransistors (T11 bzw. T12) angeordneten Widerstand (R11 bzw. R12) steuerbarer Hilfstransistor (T21 bzw. T22) vorgesehen sind, über den bei Fließen eines Überstromes auf der Sendeleitung (SL) ein zusätzlicher Basisstrom für den betreffenden Schalttransistor (T11, T12) erzeugt wird, daß die eine Ader der Sendeleitung (SL) mit dem Verbindungspunkt zwischen den Emitterstrecken der beiden Schalttransistoren (T11, T12) und die andere Ader der Sendeleitung (SL) über eine für jeweils eine Stromrichtung durchlässige Diode (D11 bzw. D12) mit dem Ver-bindungspunkt zwischen jeweils einem Wider-stand und einem Hilfstransistor (R11, T21 bzw. R12, T22) verbunden ist und daß ein durch einen Widerstand (Rp) überbrückter Kaltleiter (Rk) in einer dieser Adern angeordnet ist.

## Claims

1. Circuit arrangement for the protection of electronic transmitting- and receiving-devices against excess current in systems of direct current telegraphy technology, characterised in that in each case in one section of a transmitting- and/or a receiving-line there are arranged a positive-temperature-coefficient resistor (Rk) and a linear resistor (Rp) which is connected in parallel with the latter, that there are provided a resistor (R1) which is arranged in the collector terminal of a switching transistor (T1) positioned in the transmitting device, and an auxiliary transistor (T2) of the opposite conductivity type which lies in parallel with the collector-base path of the switching transistor (T1) and which can be controlled by means of the voltage drop at the resistor (R1) and via which an additional base current for the switching transistor (T1) is produced when an excess current flows on the terminal line (SL).

2. Circuit arrangement as claimed in Claim 1, characterised in that between the base terminal of the switching transistor (T1) and the base terminal of the auxiliary transistor (T2) there is arranged a capacitor (C1).

3. Circuit arrangement as claimed in one of the Claims 1 or 2, characterised in that in the collector path of the auxiliary transistor (T2) there is arranged a further resistor (R2).

4. Circuit arrangement as claimed in one of the Claims 1 to 3, characterised in that in the base current circuit of the auxiliary transistor (T2) there is arranged a response delay circuit (R3, C2).

5. Circuit arrangement for transmitting- and receiving-devices which are operated independently of polarity as claimed in one of the Claims 1 to 4, characterised in that between the terminals for the data received (ED) and the receiving line (EL) there is arranged a bridge rectifier circuit (B), that between the terminals for the data to be transmitted (SD) and the transmitting line (SL) there are arranged switching transistors (T11 and T12) and in each case an auxiliary transistor (T21 and T22) which can be controlled via the resistor (R11 and R12) which is arranged in the collector terminal of the respective switching transistor (T11 and T12) and by means of which auxiliary transistor (T21 and T22) an additional base current for the particular switching transistor (T11, T12) is produced when an excess current flows on the transmitting line (SL), that the one section of the transmitting line is connected to the junction between the emitter paths of the two switching transistors (T11, T12) and the other section of the transmitting line (SL) is connected via respective diodes (D11, D12), which are conducting for respective current directions, to the junctions between a respective resistor and a respective auxiliary transistor (R11, T21 and R12, T22), and that a positive-temperature-coefficient resistor (Rk) which is bridged by a resistor (Rp) is arranged in one of these sections.

## Revendications

1. Montage pour la protection de dispositifs électroniques d'émission et de dispositifs électroniques de réception contre de surintensités dans des installations de la technique de télégraphie à courant continu, caractérisé par le fait qu'il est prévu respectivement dans un fil d'une ligne d'émission et/ou de réception, un conducteur à froid (Rk) et une résistance linéaire (Rp) branché en parallèle sur ce conducteur, et qu'il est prévu une résistance (R1), reliée à la borne de collecteur d'un transistor de commutation (T1) prévu dans le dispositif d'émission, et un transistor auxiliaire (T2) possédant le type de conductivité opposé et branché en parallèle sur la voie collecteur-base du transistor de commutation (T1) et qui peut être commandé par la chute de tension dans la résistance (R1) et par l'intermédiaire duquel un courant de base supplémentaire pour le transistor de commutation (T1) est produit lors du passage, d'une surintensité dans le conducteur de raccordement (SL).

2. Montage suivant la revendication 1, caractérisé par le fait qu'un condensateur (C1) est disposé entre la borne de base du transistor de commutation (T1) et la borne de base du transistor auxiliaire (T2).

3. Montage suivant l'une des revendications 1 ou 2, caractérisé par le fait qu'une résistance supplémentaire (R2) est disposée dans le circuit du collecteur du transistor auxiliaire (T2).

4. Montage suivant l'une des revendications 1 à 3, caractérisé par le fait qu'un circuit (R3, C2) de retard de réponse est prévu dans le circuit de base du transistor auxiliaire (T2).

5. Montage pour des dispositifs d'émission et des dispositifs de réception, fonctionnant indépendamment de la polarité, suivant l'une des revendications 1 à 4, caractérisé par le fait qu'il est prévu un montage redresseur en pont (B) entre les bornes pour les données de réception (ED) et la ligne de réception (EL), qu'il est prévu entre les bornes pour les données d'émission (SD) et la ligne d'émission (SL), des transistors de commutation (T11, T12) et respectivement un transistor auxiliaire (T21, T22) pouvant être commandé par l'intermédiaire de la résistance (R11, R12) relié à la borne du collecteur de chaque transistor de commutation (T11, T12) et par l'intermédiaire duquel, lors du passage d'une surintensité dans la ligne d'émission (SL), se trouve produit un courant de base supplémentaire pour le transistor de commutation concerné (T11, T12), qu'un fil de la ligne d'émission (SL) est relié au point de liaison entre les bornes d'émetteur des deux transistors de commutation (T11, T12) et que l'autre fil de la ligne d'émission (SL) est relié par l'intermédiaire d'une diode (D11, D12), passante pour un sens du courant, au point de liaison entre respectivement une résistance et un transistor auxiliaire (R11, T21; R12, T22), et qu'un conducteur à froid (Rk), shunté par une résistance (Rp), est disposé dans l'un de ces fils.

FIG 1

FIG 2

1

**FIG 3**